# EUROPEAN PATENT APPLICATION

(11) **EP 4 730 039 A1**
(43) Date of publication of application: **22.04.2026**
(21) Application number: 25209112.9
(22) Date of filing: 16.10.2025
(51) Int. Cl.: G03F 7/30

(54) **METHOD FOR DEVELOPING A FLEXOGRAPHIC PLATE AND APPARATUS FOR IMPLEMENTING SUCH METHOD**

(30) Priority: 18.10.2024 IT 202400023271
(71) Applicant: Vianord Engineering Sasu, 06510 Carros (FR)
(72) Inventor: SASSANELLI, Pier Luigi, 06800 Cagnes-sur-Mer (FR)
(74) Representative: De Bortoli, Tiziano

(57) **Abstract**

The present invention relates to a method for developing a flexographic plate (5), wherein said developing method comprises the step of providing washing means for washing the plate (5) by means of mechanical brushes (17) and a water-based liquid or a solvent-based liquid. The method further comprises the step of providing heating means for heating said face to be developed (5B) of the plate (5). The method according to the invention further comprises the step of heating, by means of said heating means, the face to be developed (5B) of the plate (5) to a predetermined temperature and the step of washing the plate (5) by means of said washing means (10) when the face to be developed (5B) of the plate 5 has reached said predetermined temperature.

## Description

### FIELD OF THE INVENTION

The present invention relates to the field of processes for preparing analogue and/or digital printing plates for flexography. In particular, the present invention relates to a method for developing a flexographic plate and to an apparatus for implementing such method.

### PRIOR ART

Flexography is a direct rotary printing method which uses relief plates made of photopolymer materials. The plates are flexible and soft, hence the name flexography. Such plates are inked, and printing is achieved by direct deposition of the ink on the substrate to be printed, by means of a light pressure exerted by a printing cylinder on which the plates are positioned.

Flexography is a high-speed printing process, capable of printing on many types of absorbent and non-absorbent materials. Some typical applications of flexographic printing are the production of paper and plastic bags, milk cartons, disposable cups and the like, however, thanks to advances in print quality, flexography is now also used, for example, to print newspapers as well as packages and labels and for printing on plastic, acetate films and sheets, wrapping paper and many other materials used for product packaging.

*"Digital flexography"* is a particular flexographic printing process in which digital plates are used. In such plates, the photopolymer is originally covered with a surface layer of material that prevents photo-exposure, such as a carbon or graphite layer. This layer of material is etched to create a negative image of the print subject. Typically, such etching step is performed using a digital laser, controlled by a computer (hence the acronym CTP, *"Computer to Plate ",* used to indicate this step of the pre-printing process in the field). Subsequently, the plate is then photo-exposed and the material not exposed to light is then removed in an operation usually referred to as "plate development".

According to a first known technique, a flexographic plate is developed *"thermally",* that is, through a process which involves the removal of the non-photo-exposed polymer or monomer through contact with absorbent material, wherein such contact occurs when the non-photo-exposed polymer or monomer is brought to a temperature such that it is melted, so as to flow into the absorbent material and therefore so as to be able to be removed through contact with the latter.

According to a second known technique, relating to the present invention, the plates are developed by washing them, which may be carried out using a solvent-based liquid or a water-based liquid. In any case, a mechanical, in most cases rotary, action of brushes is contemplated, wherein the brushes act on the face of the plate to be developed to promote the detachment of the monomer *(or polymer)* previously not exposed to light. The liquid used for washing *(whether solvent-based or water-based)* is sprayed onto the brushes. In detail, the solvent-based liquid dissolves the non-photo-exposed monomer (or polymer). When washing with a water-based liquid, the brushes require a stronger mechanical action since water alone cannot dissolve the monomer or polymer but only softens it.

Following washing, flexographic plates require treatment to remove the solvent or water absorbed during the washing process. This treatment is called "drying" of the plate and is carried out in an apparatus typically comprising heating means configured to heat the air around the plate so as to cause the evaporation of the solvent or water contained in the plate.

Practice has shown that washing, whether with solvent or water-based, is a particularly critical operation in terms of operating costs. In fact, in order to develop the plate correctly *(i.e. in order to eliminate the polymer - or monomer - to a suitable extent)* the brushes must exert their mechanical action on the plate for a relatively long time. In the case of washing with a water-based liquid, the operating times are longer than those for washing with a solvent-based liquid.

In an in-line system, such as e.g. the one described and shown in EP2839345, for example, the times for washing with a water-based liquid, expressed as feed rate in the washing station, are in the order of 60-80 mm/min, while in the case of washing with a solvent-based liquid they are in the order of 120-150 mm/min. In any case, these times have a strong and negative impact on the overall times for preparing the plate and consequently on the final production costs.

To speed up the washing operation of the plates, alternative solutions have been considered which in any case involve increasing the number of brushes. While this solution allows for shorter operating times, it also has some drawbacks. The first of these is the size of the washing station *(or apparatus),* which significantly increases as the number of brushes increases. This aspect translates into an increase in the overall costs of building the washing station (or apparatus).

Practice has also shown that as the number of brushes increases, the amount of liquid absorbed by the plate increases. In fact, since the liquid spraying is carried out at each individual brush, the amount of liquid that reaches the brush is thus proportional to the number of brushes. Therefore, keeping the overall volume of liquid used the same, increasing the number of brushes increases the quantity of liquid that hits the plate, even if for a shorter time. Especially in the case of solvent-based liquid, the greater irrigation of the surface of the plate to be developed leads to a greater absorption of liquid and this negatively translates into exponentially higher drying times.

### SUMMARY

In light of the above considerations, the main task of the present invention is to provide a new method for developing a flexographic plate which allows the above-mentioned drawbacks to be overcome or at least mitigated.

Within the scope of this task, a first object of the present invention is to provide a method that allows a flexographic plate to be developed in shorter times than those currently permitted by traditional solutions.

Another object of the present invention is to provide a development method that allows the amount of washing liquid and/or the exposure times to the same to be reduced so as not to affect the drying treatment.

Another object, linked to the previous one, is to provide a method for developing a flexographic plate that allows for greater productivity compared to traditional methods, without requiring an increase in the number of brushes and/or a change in the composition of the *(water-based or solvent-based)* washing liquid currently used.

Another object of the present invention is to provide a method for developing a flexographic plate that can be implemented easily and at competitive costs.

The Applicant has found that the intended task and objects may be achieved by heating the face of the plate to be developed *(on which the polymer or monomer to be removed is located)* preferably up to a temperature in the range of between 35° and 75°, wherein such heating is carried out before washing the plate itself *(with a solvent-based solution or with a water-based solution)* and therefore before the mechanical brushes used for washing act on the heated face 5B to be developed.

The Applicant has found that, keeping the technical features of the flexographic plate the same *(i.e. keeping dimensions and constituent materials the same),* heating the side of the plate to be developed allows for a reduction of approximately 20% in the washing and drying times of the plate compared to traditional solutions.

In particular, the above-mentioned task and objects are achieved through a method for developing a flexographic plate, wherein said plate comprises a base face and a face to be developed, opposite to said base face, wherein said development method comprises the steps:
a) providing washing means for washing said flexographic plate with a water-based liquid or with a solvent-based liquid;
b) providing heating means for heating said face to be developed of the flexographic plate;
c) heating, by means of said heating means, said face to be developed of said flexographic plate to a predetermined temperature;
d) washing said flexographic plate by means of said washing means when *(or after)* said face to be developed has reached said predetermined temperature.

It has been observed that heating the face to be developed of the plate allows for easier, and therefore faster, removal of the non-photo-exposed polymer *(or monomer).* This, keeping the same washing means the same, translates into reduced operating times and therefore greater productivity as compared to known solutions.

Preferably, the preferred temperature to which the face to be developed is heated lies within a range of between 35° and 75 C°.

In one possible embodiment, the heating means are configured to heat the face to be developed of said plate by radiation.

In this regard, the heating means comprise an infrared lamp. Alternatively, the heating means comprises a radiating element made of a metallic material heated by means of an electrical resistance.

In an alternative embodiment, the heating means are configured to heat the face to be developed of said plate by thermal contact. In one embodiment thereof, such means comprise a cylinder made of a metallic material heated by means of an electrical resistance.

The present invention also relates to an apparatus for developing a flexographic plate, wherein said flexographic plate comprises a base face and a face to be developed opposite said base face, wherein said apparatus comprises washing means for washing said plate with a water-based or solvent-based liquid, characterised by comprising heating means operatively arranged upstream of said washing means so as to heat said face to be developed of said flexographic plate before said washing means act on said face to be developed.

According to a possible preferred embodiment, said washing means comprise:
- a washing chamber provided with an inlet section for said plate and an outlet section for said plate opposite said inlet section;
- a plurality of brushes arranged inside said washing chamber;
- feeding means of said water-based or solvent-based liquid to feed said liquid into said chamber,
   wherein said heating means are arranged outside said washing chamber near said inlet section. In this way, the plate enters the washing chamber immediately after the side to be developed has been heated.

Preferably, said apparatus comprises drive means for driving said plate through said inlet section, from a position completely external to said washing chamber to a position completely internal to said washing chamber.

The present invention also relates to an in-line system for preparing a flexographic plate comprising a base face and a face to be developed opposite to said first face, wherein said in-line system comprises:
- a first station for etching said plate, wherein said etching is performed on said face to be developed;
- a second station for photo-exposing portions of said face to be developed, wherein said second station is operatively downstream of said first station;
- a third station for washing said plate by means of mechanical brushes and with a water-based or solvent-based liquid, to remove portions of said face to be developed that have not been photo-exposed at said second station, wherein said third station is operatively downstream of said second station;
- a fourth station for drying said plate, wherein said fourth station is operatively downstream of said third station;
characterised by comprising heating means for heating said face to be developed of said plate, wherein said heating means are arranged downstream of said second station and upstream of said third station.

### LIST OF FIGURES

Further features and advantages of the present invention will become apparent from the following detailed description of a method and an apparatus according to the invention, provided by way of non-limiting example and illustrated in the accompanying figures, in which:
- Figures 1 to 4 are schematic views of an embodiment of an apparatus for implementing a method according to the invention, where each figure refers to an operation step of the apparatus;
- Figure 5 is a schematic view of an in-line plant for the preparation of a flexographic plate in which the method according to the invention is implemented;

Identical reference numbers and letters in the figures refer to identical elements or components.

### DETAILED DESCRIPTION

With reference to the aforementioned figures, the present invention therefore relates to a method for developing a flexographic plate 5 *(or plate 5)* which has a first face 5A *(or base face 5A)* and a second face 5B *(or face to be developed 5B).* For the purposes of the present invention, the second face 5B, to be developed, is the face comprising polymer *(or monomer)* to be removed, as it has not been photo-exposed to light previously. The first base face 5A is opposite the second face 5B and typically does not include any polymer *(or monomer)* portions to be removed. The first face 5A is the face of the plate 5 close to which a layer of Mylar *(or other functionally equivalent material)* suitable for providing strength to the plate is typically provided, according to a principle known per se.

The developing method according to the invention comprises the steps:
a) providing washing means 10 for washing the flexographic plate 5 by means of mechanical brushes 18 with a water-based liquid or a solvent-based liquid;
b) providing heating means 20 for heating the second face 5B of the plate 5;
c) heating, by means of said heating means 20, the second face 5B, to be developed, of the plate 5 up to a predetermined temperature;
d) washing the flexographic plate 5 by means of said washing means when the second face 5B of the plate 5 has reached said predetermined temperature.

In step c), the predetermined temperature lies preferably within a range of between 35 °C and 75 °C.

The method according to the present invention therefore provides for heating the face to be developed 5B of the plate 5 to a predetermined temperature before washing the plate 5 with a water-based or solvent-based liquid. In particular, washing of plate 5 can be carried out without increasing the number of brushes and/or without changing the composition and/or amount of washing liquid as compared to what is contemplated in traditional solutions. In fact, keeping washing means and final washing quality the same, heating the face to be developed 5B *(step c)* of plate 5 still allows for a reduction in washing times.

For the purposes of the present invention, the expression *"washing of plate"* is intended to mean a washing carried out on the face to be developed 5B using mechanical brushes which remove the non-photo-exposed polymer *(or monomer)* according to a principle known per se.

According to a preferred embodiment, the heating of the second face 5B of the plate 5 is carried out by moving it relative to the heating means 20. In this way, the second face 5B heats up gradually. Therefore, washing of plate 5 can be carried out gradually as well. In practice, the washing means 10 can wash a portion of the second face 5B, while another portion is subjected to heating. Basically, the washing of the second face 5B of the plate 5 can take place, at least in a certain time interval, simultaneously with the heating of the second face 5B itself.

According to an alternative embodiment, the plate 5 can be washed when the entire surface of the second face 5B has reached the predetermined heating temperature. In other words, step d) may be carried out subsequently to, and therefore not simultaneously with, step c).

The predetermined heating temperature can be established based on the material forming the flexographic plate and/or based on the type of liquid *(solvent-based or water-based)* used for washing. In this regard, keeping structure of the plate the same, the predetermined heating temperature may preferably *(but not exclusively)* be lower if a solvent-based liquid is used.

In a possible embodiment thereof, the heating means 20 are configured to heat the face to be developed 5B of the plate 5 through a transfer of thermal energy by radiation. In this regard, the heating means 20 preferably comprise one or more infrared lamps. Alternatively, the heating means 20 may comprise a radiant body made of a metallic material heated by an electrical resistance.

Preferably, but not exclusively, radiating heating means are used when the predetermined heating temperature is relatively high *(e.g. above 50°).*

According to an alternative embodiment, the heating means 20 are configured to heat the face to be developed 5B of the plate 5 by thermal contact *(i.e. through heat transfer carried out by conduction).* In this case, the heating means 20 may comprise a cylinder made of a metallic material heated by an electrical resistance.

Thermal contact heating means can be used when the predetermined heating temperature is relatively low, for example between 35°C and 50°C.

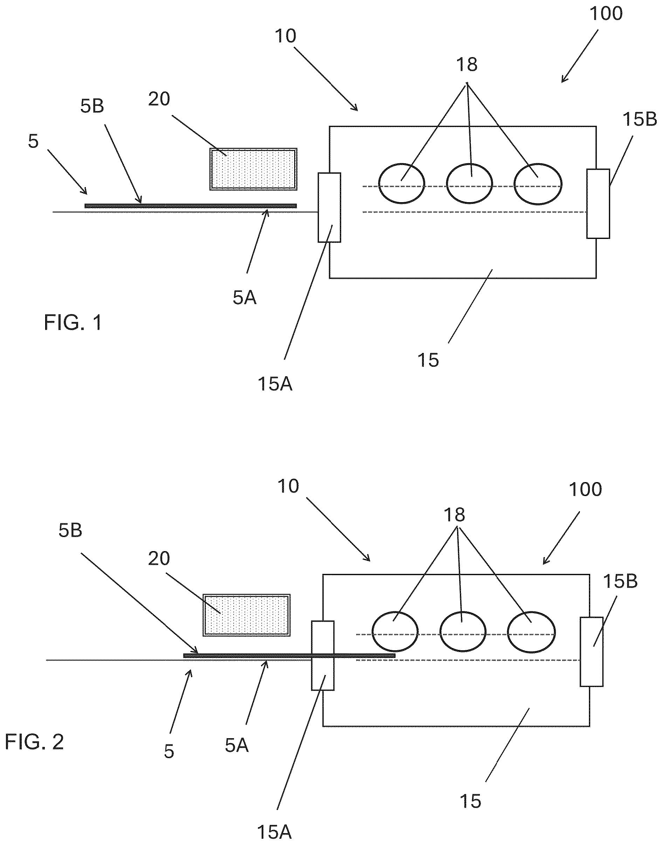

In any case, as already indicated above, the heating of the face to be developed 5B of the plate 5 is preferably achieved through a relative movement of the plate 5 relative to the heating means 20, as better described below with reference to Figures 1 to 4.

The present invention also relates to a development apparatus 100 for developing a flexographic plate 5 which allows the method according to the present invention to be implemented. The apparatus 100 according to the invention comprises washing means 10 configured to wash a plate 5 with a solvent-based or water-based liquid.

The apparatus 100 is characterised in that it comprises heating means 20 for heating the face to be developed 5B of the plate 5 up to a predetermined temperature, wherein such heating means 20 are operatively arranged upstream of the washing means 10 so that each portion of the face to be developed 5B of the plate 5 is heated before the washing means act on the portion itself.

Figures 1 to 4 schematically show a possible embodiment of an apparatus 100 according to the invention. The washing means 10 comprises a washing chamber 15 *(or washing station 15)* provided with an inlet section 15A and an outlet section 15B, preferably opposite to said inlet section 15A. The washing means 10 comprise a plurality of brushes 18 arranged inside the washing chamber 15. The brushes 18 can be of the rotary type or, alternatively, they can be translating brushes, i.e. brushes movable on a movement plane.

The washing means 10 comprise means for supplying the water-based or solvent-based liquid. In practice, such feeding means *(for example in the form of nozzles)* allow the liquid to be sprayed onto the plate 5 *(in particular onto the face to be developed 5A)* at each brush 18, wherein the spraying can begin even before the activation of the brushes 18. In any case, the spraying of a brush 18 is active as long as the same brush 18 acts on the plate 5.

Preferably, the washing means 10 comprise means for recirculating the washing liquid (not shown in the figure) and, when water-based liquids/solutions are used, preferably also filtering means *(not shown in the figure)* for filtering the mixture made up of the liquid and the polymer (or monomer) resulting from the action of the brushes.

Still referring to Figures 1 to 4, the heating means 20 are positioned outside the washing chamber 15 in proximity to the inlet section 15A. In this way, the plate 5 can be heated gradually and can enter the washing chamber 15 just as gradually.

The heating means 20 of the apparatus 100 according to the invention can be of the types already mentioned above with reference to the method for developing the flexographic plate indicated above. Therefore, in this regard, reference is made to what has already been indicated above.

In order to allow the movement of the plate 5, the apparatus 100 comprises means for driving the plate 5 *(not shown in the figures).* In one embodiment, the drive means move a pin-bar *(or transport bar)* to which the plate 5 is attached at one of its edges, according to a principle known per se. The drive means allow the pin-bar and the plate 5 to advance relative to the heating means 20, as well as the plate 5 to enter into, and exit from, the washing chamber 15.

Figure 1 shows the apparatus 100 in a first operating step corresponding to the start of heating of the face to be developed 5B. Through the drive means, the plate 5 is made to advance towards the inlet section 15A of the washing chamber 15 at a certain advancement speed. This is established taking into account the time required for the brushes 18 to completely remove all the non-photo-exposed polymer (or monomer). Consequently, the intensity *(in terms of transferred thermal power)* of the heating means 20 is set in such a way that the face to be developed 5B of the plate 5 enters the washing chamber 15 when the predetermined temperature is reached.

Figure 2 shows the apparatus 100 in a subsequent advancement step of the plate 5, when the latter is partially outside and partially inside the washing chamber 15. In this condition, washing can be carried out on a front portion *(with respect to the direction of advancement of the plate indicated by arrow F),* while an upstream portion is heated.

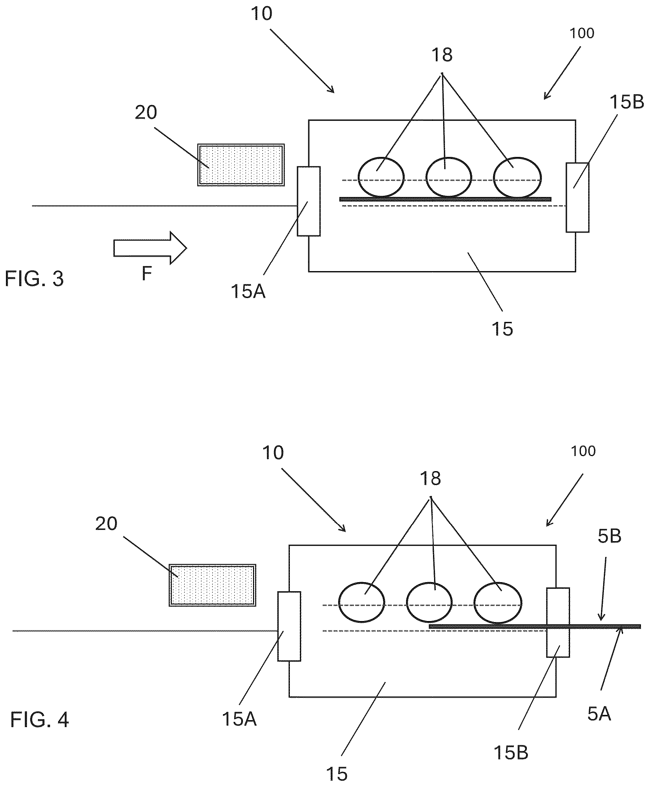

Figure 3 shows the apparatus 100 in a further step in which the entire plate 5 is inside the washing chamber 15, when the action of the heating means 20 has ended. Finally, Figure 4 shows the apparatus 100 in a further step, in which the plate 5 has partially come out from the washing chamber 15.

Compared to known solutions, keeping washing means 10 the same, the use of heating means 20 allows for a greater speed of advancement of the plate 5 in the washing chamber 15, which translates into a lower liquid absorption by the plate 5 and therefore into a reduction in the time required for the subsequent drying step.

The present invention also relates to an in-line system 200 for preparing a flexographic plate 5 which comprises a base face 5A and a face to be developed 5B, wherein the latter, during the use of the plate 5, is intended to be inked to allow printing on a support.

Such in-line system 200 comprises a plurality of stations in which a respective preparation step of the plate 5 is carried out. The latter is moved from one operating station to the next by means of drive means (for example, by means of a transport bar).

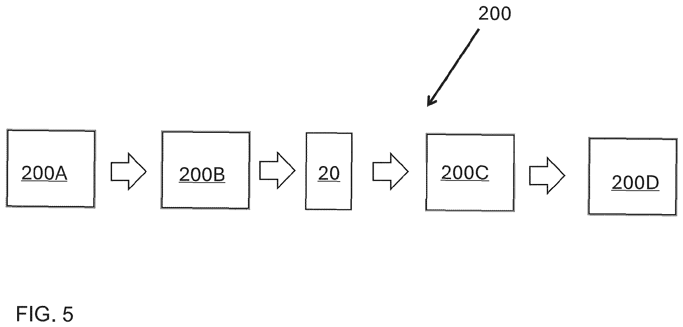

Figure 5 schematically shows a possible embodiment of an in-line system 200 in which the method according to the invention is implemented. In particular, such a system comprises:
- a first station 200A for etching said plate 5, wherein said etching is performed on said face to be developed 5B of said plate 5;
- a second station 200B for photo-exposing portions of said face to be developed 5B of said plate 5, wherein said second station 200B is operatively downstream of said first station 200A;
- a third station 200C for washing said plate 5 by means of mechanical brushes and with a water-based or solvent-based liquid, so as to remove portions of said face to be developed 5B that have not been photo-exposed at said second station 200B, wherein said third station 200C is operatively downstream of said second station 200B;
- a fourth station 200D for drying said plate 5, wherein said fourth station 200D is operatively downstream of said third station 200C.

The in-line system is characterised by comprising heating means 10 for heating the face to be developed 5B of the plate 5, wherein said heating means 10 are arranged downstream of the second station 200B and upstream of the third station 200C.

As already indicated above, the use of the heating means 20 in the indicated position allows increasing the advancement speed of the plate 5 in the washing station 200C and at the same reducing the residence times of the same plate 5 in the drying station 200D. This positively affects the productivity of the in-line system 200.

The described technical solutions allow the set tasks and objects to be fully achieved. In particular, the method and apparatus according to the invention allow a greater productivity, and therefore an overall reduction in the overall costs for producing the plate, to be achieved.

## Claims

1. Method for developing a flexographic plate (5), wherein said plate (5) comprises a base face (5A) and a face to be developed (5B), opposite said base face (5A), wherein said method comprises the steps:
a) providing washing means (10) for washing said plate (5) by means of mechanical brushes (17) and with a water-based liquid or a solvent-based liquid;
b) providing heating means (20) for heating said face to be developed (5B) of said plate (5);
c) heating, by means of said heating means (20), said face to be developed (5B) of said plate (5) to a predetermined temperature;
d) washing said plate (5) by means of said washing means (10) after said face to be developed (5B) reached said predetermined temperature.

2. Method according to claim 1, wherein said predetermined temperature lies within a range of between 35 °C and 75 °C.

3. Method according to claim 1 or 2, wherein said heating means (20) heat said face to be developed (5B) of said plate (5) by radiation.

4. Method according to claim 3 wherein said heating means (20) comprise an infrared lamp and/or a radiating element made of a metallic material heated by means of an electrical resistance.

5. Method according to claim 1 or 2, wherein said heating means (20) are configured to heat said face to be developed (5B) of said plate (5) by a thermal contact therewith.

6. Method according to claim 5, wherein said heating means (20) comprise a cylinder made of a metallic material heated by means of an electrical resistance.

7. Apparatus (100) for developing a flexographic plate (5), wherein said plate (5) comprises a base face (5A) and a face to be developed (5B) opposite said base face (5A), wherein said apparatus (100) comprises washing means (10) including mechanical brushes (18) for washing said face to be developed (5B) with a water-based or solvent-based liquid, **characterised by** comprising heating means (20) operatively arranged upstream of said washing means (10) so as to heat said face to be developed (5B) of said plate (5) before said washing means (10) act on said face to be developed (5B).

8. Apparatus (100) according to claim 7, wherein said washing means (10) comprise:
- a washing chamber (15) provided with an inlet section (15A) for said plate (5) and an outlet section (15B) for said plate (5) opposite said inlet section (15A);
- a plurality of brushes (18) arranged inside said washing chamber (15);
- feeding means to spray a water-based or solvent-based liquid at said brushes (18), wherein said heating means (10) of said apparatus (100) are arranged outside said washing chamber (15) near said inlet section (15A).

9. In-line system (200) for preparing a flexographic plate (5), wherein said plate (5) comprises a base face (5A) and a second face to be developed (5B) opposite said base face (5A), wherein said in-line system (200) comprises:
- a first station (200A) for etching said plate (5), wherein said etching is performed on said face to be developed (5B);
- a second station (200B) for photo-exposing portions of said face to be developed (5B) of said plate (5), wherein said second station (200B) is operatively downstream of said first station (200A)
- a third station (200C) for washing said plate (5) by means of mechanical brushes and with a water-based or solvent-based liquid, wherein said washing is performed to remove portions of said face to be developed (5B) that have not been photo-exposed at said second station (200B), wherein said third station (200C) is operatively downstream of said second station (200B),
- a fourth station (200D) for drying said plate (5), wherein said fourth station (200D) is operatively downstream of said third station (200C),
**characterised by** comprising heating means (20) for heating said face to be developed (5B) of said plate (5), wherein said heating means (20) are arranged downstream of said second station (200B) and upstream of said third station (200C).
